# EUROPEAN PATENT APPLICATION

(11) **EP 4 498 436 A1**
(43) Date of publication of application: **29.01.2025**
(21) Application number: 24182762.5
(22) Date of filing: 18.06.2024
(51) Int. Cl.: H01L 29/78

(54) **SEMICONDUCTOR DEVICE WITH MULTIPLE GATES AND RELATED METHOD**

(30) Priority: 28.07.2023 US 202318361497
(71) Applicant: Avago Technologies International Sales Pte. Limited, Singapore 768923 (SG)
(72) Inventor: Liu, Qing, Irvine, 92602 (US)
(74) Representative: Bosch Jehle Patentanwaltsgesellschaft mbH

(57) **Abstract**

Novel semiconductors and fabrication techniques are provided. In various embodiments, a semiconductor includes a source, a drain, a first gate, a second gate, and a channel. The second gate is electrically coupled to the first gate. The first gate and the second gate are configured to control current between the source and the drain. The channel is in contact with the first gate and the second gate. The channel is configured such that the current flows through the channel. Other aspects, embodiments, and features are also claimed and described.

## Description

A portion of the disclosure of this patent document contains material that is subject to copyright protection. The copyright owner has no objection to the facsimile reproduction by anyone of the patent document or the patent disclosure as it appears in the Patent and Trademark Office patent file or records, but otherwise reserves all copyright rights whatsoever.

The present disclosure relates, in general, to methods, systems, and apparatuses for implementing semiconductor technology, and, more particularly, to methods, systems, and apparatuses for implementing field-effect transistors for high voltage application.

Field-effect transistors (FETs) have been extensively utilized in various electronic applications due to their ability to efficiently control the flow of electrical current. Among FETs, Laterally-Diffused Metal-Oxide-Semiconductors (LDMOS) can be used in high-power applications, such as power amplifiers, RF (Radio Frequency) amplifiers, and power transistors for radio and wireless communication systems.

As the demand for high-power applications continues to increase, research and development continue to advance LDMOS technologies not only to meet manufacturing capabilities and capacities of foundries producing LDMOS, but to advance and enhance the high-power applications using the LDMOS transistors.

The techniques of this disclosure generally relate to tools and techniques for implementing semiconductor technology, and, more particularly, to methods, systems, and apparatuses for a semiconductor device and/or a semiconductor device processing process.

In an aspect, a semiconductor device includes a source, a drain, a first gate, a second gate, and a channel. The second gate is electrically coupled to the first gate. The first gate and the second gate are configured to control current between the source and the drain. The channel is electrically coupled to the first gate and the second gate. The channel is configured for the current to flow through the channel.

In some embodiments, the semiconductor device further comprises a connector directly positioned on the first gate and the second gate to physically connect the first gate to the second gate.

In some embodiments, a first distance of the first gate in a direction from the source to the drain is longer than a second distance of the second gate in the direction from the source to the drain.

In some embodiments, the channel is electrically coupled to the second gate by being in contact with the second gate.

In some embodiments, the channel comprises a first channel and a second channel. The first channel is in contact with the first gate, and the second channel is in contact with the second gate. The semiconductor device further comprises a fin positioned between the first channel and the second channel.

Accordingto some embodiments, the first gate is positioned on the first channel, and the second gate is positioned on the second channel.

According to some embodiments, the fin is positioned between the first gate and the second gate.

In some embodiments, the channel consists of a single channel in contact with both of the first gate and the second gate.

In some embodiments, the semiconductor device further comprises a second channel, the channel and the second channel being positioned in parallel relatively to each other in a direction between the source and the drain.

In some embodiments, the channel comprises: silicon, silicon-germanium, or germanium.

In some embodiments, the source comprises a first fin, and the drain comprises a second fin.

According to some embodiments, the first fin and the second fin comprise an in-situ phosphorous or boron doped epitaxy.

In some embodiments, the semiconductor device further comprises a substrate, a sfirst well positioned on the substrate, and a second well positioned on the substrate. The source is positioned on the first well. The drain is positioned on the second well, the channel is positioned on the first well. The first gate is positioned on the first well.

According to some embodiments, the second gate is in contact with the channel, and the second gate is positioned over at least one of the first well or the second well.

In annother aspect, a method for processing a semiconductor device comprises: forming a first well and a second well on a substrate; forming a channel on the first well and the second well; forming a first gate and a second gate; and forming a source on the first well and a drain on the second well. The first gate is electrically coupled to the second gate, and the channel is in contact with the first gate and the second gate.

In some embodiments, the method further comprises: directly positioning a connector on the first gate and the second gate to physically connect the first gate to the second gate.

In some embodiments, the channel comprises a first channel and a second channel. The first channel is in contact with the first gate, and the second channel is in contact with the second gate. The method further generates a fin positioned between the first channel and the second channel.

According to some embodiments, the first gate is positioned on the first channel, and the second gate is positioned on the second channel.

According to some embodiments, the fin is positioned between the first gate and the second gate.

In a further aspect, a semiconductor device includes a source, a drain, a first gate, a second gate, a connector, and a channel. The first gate and the second gate are configured to control current between the source and the drain. The connector is directly positioned on the first gate and the second gate to physically connect the first gate to the second gate. The channel is electrically coupled to the first gate and the second gate. The channel is configured for the current to flow through the channel.

Various modifications and additions can be made to the embodiments discussed without departing from the scope of the invention. For example, while the embodiments described above refer to particular features, the scope of this invention also includes embodiments having different combination of features and embodiments that do not include all of the above-described features.

The details of one or more aspects of the disclosure are set forth in the accompanying drawings and the description below. Other features, objects, and advantages of the techniques described in this disclosure will be apparent from the description and drawings, and from the claims.

According to an aspect, a semiconductor device is provided comprising:
a source;
a drain;
a first gate;
a second gate, the second gate being electrically coupled to the first gate, the first gate and the second gate positioned between the drain and the source;
a connector directly positioned on the first gate and the second gate; and
a channel being electrically coupled to the first gate and the second gate.

Advantageously, a first distance of the first gate in a direction from the source to the drain is longer than a second distance of the second gate in the direction from the source to the drain.

Advantageously, the channel is electrically coupled to the second gate by being in contact with the second gate.

Advantageously, the channel comprises a first channel and a second channel,
wherein the first channel is in contact with the first gate,
wherein the second channel is in contact with the second gate, and
wherein the semiconductor device further comprises a fin positioned between the first channel and the second channel.

Advantageously, the first gate is positioned on the first channel, and
wherein the second gate is positioned on the second channel.

Advantageously, the fin is positioned between the first gate and the second gate.

Advantageously, the channel consists of a single channel in contact with both of the first gate and the second gate.

Advantageously, the semiconductor device further comprises:
a second channel, the channel and the second channel being positioned in parallel relatively to each other in a direction between the source and the drain.

Advantageously, the channel comprises: silicon, silicon-germanium, or germanium.

Advantageously, the source comprises a first fin, and
wherein the drain comprises a second fin.

Advantageously, the first fin and the second fin comprise an in-situ phosphorous or boron doped epitaxy.

Advantageously, the semiconductor device further comprises:
a substrate;
a first well positioned on the substrate; and
a second well positioned on the substrate,

wherein the source is positioned on the first well,
wherein the drain is positioned on the second well,
wherein the channel is positioned on the first well, and
wherein the first gate is positioned on the first well.

Advantageously, the second gate is in contact with the channel, and
wherein the second gate is positioned over at least one of the first well or the second well.

According to an aspect, a method is provided for processing a semiconductor device, comprising:
forming a first well and a second well on a substrate;
forming a channel on the first well and the second well;
forming a first gate and a second gate, the first gate being electrically coupled to the second gate, the channel being electrically coupled to the first gate and the second gate;
directly positioning a connector on the first gate and the second gate to physically connect the first gate to the second gate; and
forming a source on the first well and a drain on the second well.

Advantageously, the channel comprises a first channel and a second channel,
wherein the first channel is in contact with the first gate,
wherein the second channel is in contact with the second gate, and
wherein the method further comprises: forming a fin positioned between the first channel and the second channel.

Advantageously, the first gate is positioned on the first channel, and
wherein the second gate is positioned on the second channel.

Advantageously, the fin is positioned between the first gate and the second gate.

According to an aspect, a semiconductor device is provided comprising:
a source,
a drain;
a first gate;
a second gate, the first gate and the second gate positioned between the drain and the source;
a connector directly positioned on the first gate and the second gate to physically connect the first gate to the second gate; and
a channel being electrically coupled to the first gate and the second gate, the channel being in contact with the second gate.

Advantageously, the channel comprises a first channel and a second channel,
wherein the first channel is in contact with the first gate,
wherein the second channel is in contact with the second gate, and
wherein the semiconductor device further comprises a fin positioned between the first channel and the second channel.

Advantageously, the fin is positioned between the first gate and the second gate.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Fig. 1 is a schematic diagram illustrating an example Laterally-Diffused Metal-Oxide-Semiconductor (LDMOS) transistor with a long gate.
Fig. 2A is a schematic diagram illustrating a side view of an example semiconductor device, in accordance with various embodiments, and Fig. 2B is a schematic diagram illustrating a sectional view of the example semiconductor device taken along line A-A of Fig. 2B, in accordance with various embodiments.
Fig. 3A is a schematic diagram illustrating a side view of another example semiconductor device, in accordance with various embodiments, and Fig. 3B is a schematic diagram illustrating a sectional view of the example semiconductor device taken along line A-A of Fig. 3B, in accordance with various embodiments.
Fig. 4 is a schematic diagram illustrating a side view of an example semiconductor device, in accordance with various embodiments.
Fig. 5 is a flow chart illustrating an exemplary process 500 for fabricating a semiconductor device, in accordance with various embodiments.

### DETAILED DESCRIPTION

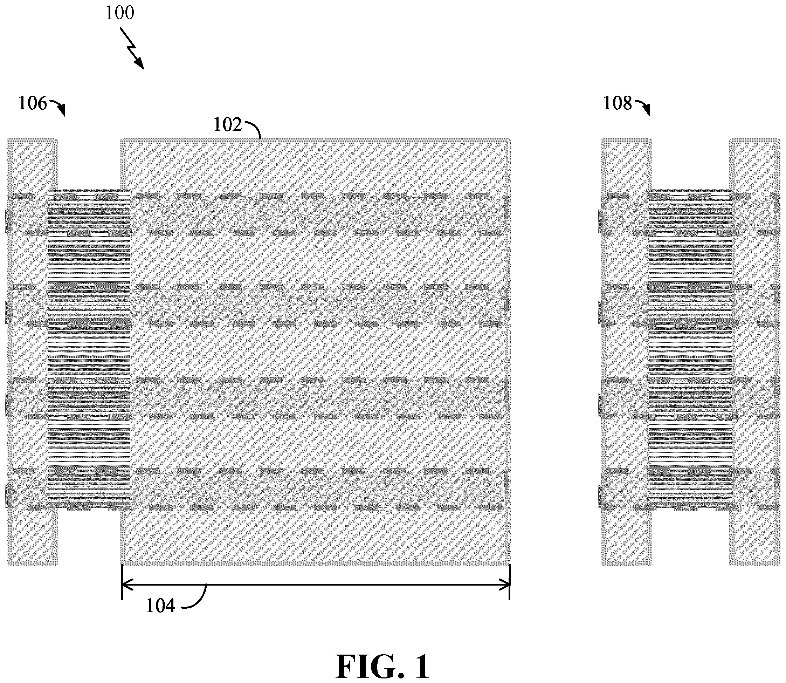

As described above, a Laterally-Diffused Metal-Oxide-Semiconductor (LDMOS) may be used in high-power applications, such as power amplifiers, RF (Radio Frequency) amplifiers, and power transistors for radio and wireless communication systems. Some LDMOS (i.e., FinFET LDMOS) may incorporates fin-like structures in the LDMOS design. The addition of fin-like structures may improve the performance and power handling capabilities of the LDMOS transistor. Some FinFET LDMOS is designed to use a foundry process, which allows a long gate length (e.g., equal to or longer than 360 nm) for the high voltage LDMOS. For example, Fig. 1 is a schematic diagram illustrating an example Laterally-Diffused Metal-Oxide-Semiconductor (LDMOS) transistor 100 with a long gate 102. In the LDMOS transistor 100, the gate distance 104 in a direction from the source 106 to the drain 108 is equal to or longer than 360 nm. However, some foundries are not able to use the long gate for FIN LDMOS. For examples, some foundries use a self-aligned contact (SAC) process in gate module. Thus, in the foundries, the maximum gate length is shorter than the long gate length (e.g., around 200nm) due to the W (tungsten) recess process included in the SAC RMG (replacement metal gate) module. The uniform recess depth of the W recess process has the limit on the longest gate length possible.

Some embodiments described herein provide solutions to these problems by providing improved semiconductors and methods for two gates and a channel in contact with the two gates. For example, the described semiconductor device includes multiple shorter gates (e.g., equal to or shorter than 300 nm) to essentially form a long gate to realize the high voltage application. Thus, some foundries which do not have foundry capacities to produce the long gate (e.g., due to the SAC process) may produce a transistor for the high voltage application. The improved semiconductor devices may be manufactured by any suitable foundries, which use the SAC process or not. In addition, the improved semiconductor devices also provide various other aspects (e.g., no additional mask or process step, or any other suitable features.).

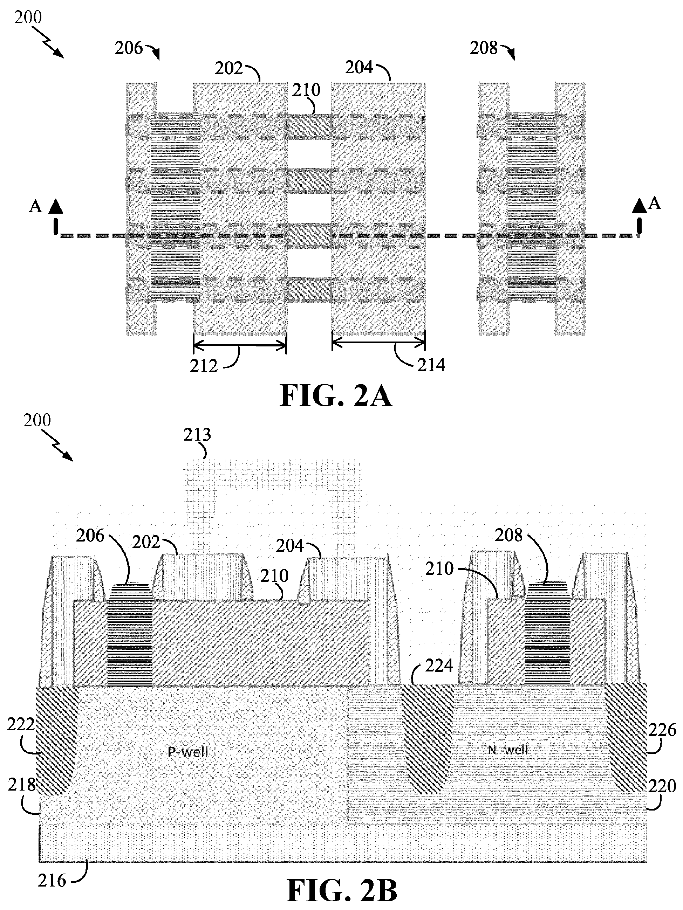

Fig. 2A is a schematic diagram illustrating a side view of an example semiconductor device 200, and Fig. 2B is a schematic diagram illustrating a sectional view of the example semiconductor device taken along line A-A of Fig. 2B. In some examples, the semiconductor device 200 may include a transistor, a field-effect transistor (FET), metal-oxide-semiconductor field effect transistor (MOSFET), a laterally-diffused metal-oxide semiconductor (LDMOS) transistor, a FinFET LDMOS transistor, and/or any other suitable semiconductor 200. For examples, the example semiconductor device 200 may include multiple gates 202, 204, a source 206, a drain 208, and/or a channel 210. In some examples, the semiconductor device 200 may control the flow of current by applying a voltage to the multiple gates, which result in the conductivity changes between the source 206 and the drain 208. Thus, the current may pass through the channel 210 from the source 206, be altered via the gates, and be reached to the drain 208.

In some examples, the semiconductor device 200 may include the multiple gates to form a long gate. In some examples, the first gate 202 may be electrically coupled to the second gate 204. The multiple gates in the semiconductor device 200 may include a first gate 202 and a second gate 204, which are configured to control current between the source 208 and the drain 206 and are positioned between the source 208 and the drain 206. In some examples, the first gate 202 and the second gate 204 can control the current together. In other examples, either the first gate 202 or the second gate 204 can control the current. In some examples, a first distance 212 of the first gate 202 in a direction from the source 206 to the drain 208 may be longer than a second distance 214 of the second gate 204 in the direction from the source 206 to the drain 208. In some scenarios, the first distance 212 of the first gate 202 may have the longest length that a foundry allows. The second distance 214 of the second gate 204 may be added to constitute the first gate 202 and the second gate 204 as a long gate. For example, the first gate 202 may have the first distance 212 for the first gate 202 may be between 160 nm and 300 nm while the second distance 214 for the second gate 204 may be between 70 nm and 300 nm. In some examples, the second distance 214 for the second gate 204 may be equal to or less than 200 nm. In other scenarios, the first gate 202 and the second gate 204 may have the same distance or any suitable distances. In some examples, the first gate 202 and the second gate 204 may extend in parallel in a second direction, which is in a right angle to the direction from the source 206 to the drain 208. In further examples, the first gate 202 and the second gate 204 may extend in parallel in the second direction to control current flowing through multiple channels 210. In other examples, the semiconductor device 200 may include more than two gates to form a long gate.

In some examples as shown in Fig. 2B, the semiconductor device 200 may further include a connector 213 positioned on the first gate 202 and the second gate 204 to connect the first gate to the second gate. In some examples, the connector 213 may be a material providing electrical contact. For example, the connector 213 may be made of tungsten or any other suitable material to electrically couple the first gate 202 to the second gate 204. For example, the connector is positioned on a first side of the first and second gates 202 while a substrate (e.g., p-well, n-well, p-type substrate, or a n-type substrate) is positioned on a second side of first and second gates 202. In some examples, the first side is an opposite side to the second side. In some examples, the connector 213 may have an inverted U shape such that the connector 213 is connected to the first side of the first and second gates 202, 204. In other examples, the connector 213 may have any other suitable shape to connect the first gate 202 and the second gate 204. Thus, in such examples, the first gate 202 and the second 204 may be electrically coupled via the physical medium, (i.e., the connector 213) to constitute a long gate. In other example, the connector may be made of copper, or any other suitable material to connect between the first gate 202 and the second gate 204.

In some examples, the semiconductor device 200 may include a channel 210, which is in contact with the first gate 202 and the second gate 204. In some examples, the first gate 202 may be positioned on the channel 210. For example, the channel 210 is electrically coupled to the source 206 and the drain 208 to carry the current from the source 206 to the drain 208 where the channel 210 is configured for the current to flow through the channel 210 such that the current flows through the channel 210. In some examples, the channel 210 may include: silicon, silicon-germanium, or germanium. In some examples, the channel 210 may be one channel in contact with the first gate 202 and the second gate 204. For example, referring again to Fig. 2B, the channel 210 may pass through the first gate 202. In some examples, the channel 210 may or may not pass through the second gate 204. Both of the first gate 202 and the second gate 204 may be in contact with the channel 210. In further examples, the semiconductor device 200 may include a second channel, which is a separate channel from the channel 210. In some examples, the second channel and the channel 210 may be positioned in parallel relatively to each other in the direction between the source 206 and the drain 208. In such examples, another channel may be in contact with both of the first gate 202 and the second gate 204.

In some examples, the semiconductor device 200 may include the source 206 and the drain 208. For example, the source 206 may include a first fin, and the drain 208 may include a second fin. In some examples, a fin (e.g., the first fin, the second fin) may be a vertical and/or protruding structure in the semiconductor device (e.g., a transistor) to improve performance and power efficiency. In some examples, each of the first fin and the second fin may include an in-situ phosphorous or boron doped epitaxy. However, it should be appreciated that each of the first fin and the second fin may be any other suitable material. In further examples, the first fin as the source 206 may be formed in the channel 210. Thus, the first fin may be positioned within the channel 210 in the direction between the source 206 and the drain 208. In some examples, the first fin may include a protruding region compared to the channel 210. In some examples, the first fin may be in contact with the first gate. In other examples, the first fin may be distanced from the first gate 202. In some examples, the second fin as the drain 208 may be formed in the channel 210. Thus, the second fin may be positioned within the channel 210 in the direction between the source 206 and the drain 208. In some examples, the second fin may include a protruding region compared to the channel 210. In other examples, the source 206 and the drain 208 may be a p-type or n-type substrate without including a fin.

In some examples, the semiconductor device 200 may further include a substrate 216, a first well 218 positioned on the substrate 216, and/or a second well 220 positioned on the substrate 216. For example, the substrate 216 may include a silicon substrate. Specifically, the substrate 216 may be a lightly boron doped P-type substrate. In other examples, the substrate 216 may be a N-type substrate or any other suitable silicon substrate.

In some examples, the first well 218 may include P-well while the second well 220 may include N-well. In further examples, the source 206 may be positioned on the first well 218 while the drain 208 may be positioned on the second well 220. In even further examples, the channel 210 may be positioned on the first well 218. Further, the first gate 202 may be positioned over the first well 218. For example, the first gate 202 may not be directly in contact with the first well 218 but the channel 210 may be positioned between the first gate 202 and the first well 218. Thus, the first gate 202 may be positioned over the first well 218 in a direction at a right angle to the direction from the source 206 to the drain 208. In some examples, the channel 210 may be positioned on the second well 220. For example, the channel 210 may be positioned partly on the second well 220. In other examples, the channel 210 may not be positioned on the second well 220. Thus, the channel 210 may not be in contact with the second well 220. In some examples, the second gate may be in contact with the channel 210, and may be positioned over at least one of the first well 218 or the second well 220. For example, the second gate 204 may be positioned partly over the first well 218 such that the channel 210 may be positioned between the second gate 204 and the first well 218 in a direction at a right angle to the direction from the source 206 to the drain 208. In further examples, the second gate 204 may be positioned partly over the second well 220 such that the channel 210 may be positioned between the second gate 204 and the second well 220 in a direction at a right angle to the direction from the source 206 to the drain 208. In further examples, the second gate 204 may be positioned partly on the second well 220 such that the second gate 204 is in contact with the second well 220.

In further examples, the first well 218 may include a first shallow trench isolation 222. In even further examples, the second well 220 may include a second shallow trench isolation 224 and a third shallow trench isolation 226. In some examples, the second shallow trench isolation 224 may be or may not be in contact with the second gate 204. The number of shallow trench isolations 222, 224, 226 is not limited to three but may be any suitable number to prevent electric current leakage.

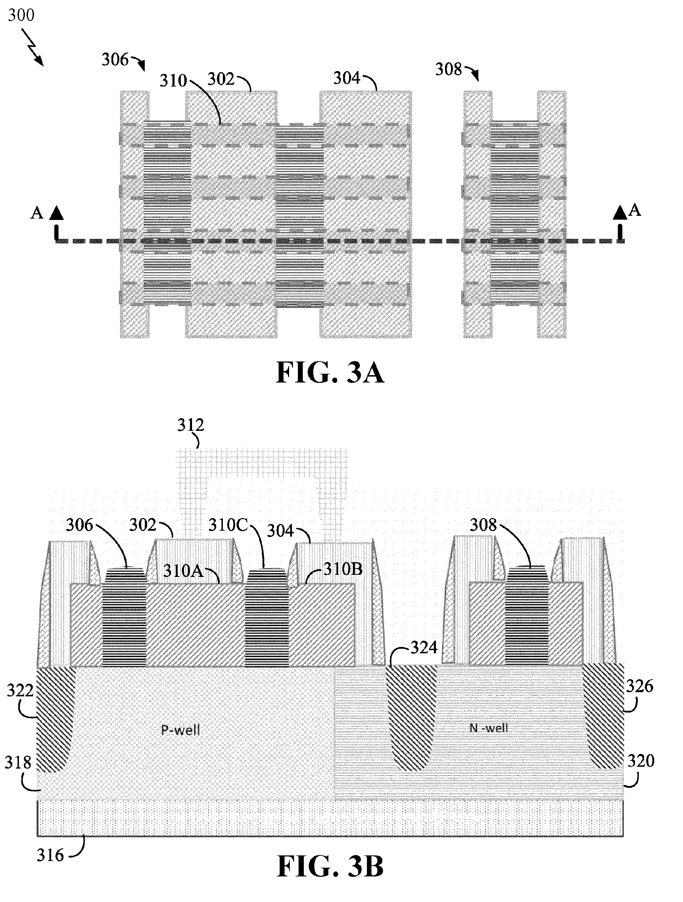

Fig. 3A is a schematic diagram illustrating a side view of another example semiconductor device, and Fig. 3B is a schematic diagram illustrating a sectional view of the example semiconductor taken along line A-A of Fig. 3B. The semiconductor device 300 in Figs. 3A and 3B may include multiple gates, a source 306, a drain 308, and/or a channel. In some examples, the multiple gates may include a first gate 302 and a second gate 304. Further, the semiconductor device 300 may further include a connector 312 to electrically couple the first gate 302 to the second gate 304. In some examples, the first and second gates 302, 304 and the connector 312 may be substantially similar to the first and second gates 202, 204 and the connector 213 in Figs. 2A and 2B. Further, the source 306 and the drain 308 may be substantially similar to the source 206 and the drain 208 in Figs. 2A and 2B.

In some examples, the channel in the semiconductor device 300 may include a first channel 310A and a second channel 310B. In further examples, the semiconductor device 300 may further include a fin positioned between the first channel 310A and the second channel 310B. In some examples, the channel can include two separate channels and a fin between the two separate channels. In some examples, the fin 310C may be inserted in the channel 210 of Fig. 2B. In further examples, the fin 310C may be inserted along with other fins (i.e., the source 306 and the drain 308). The fin 310C may be substantially similar to other fins (i.e., the source 306 and the drain 308). For example, the fin 310C may be made of an in-situ phosphorous or boron doped epitaxy. However, it should be appreciated that the find 310C may be made of any other suitable material. In some examples, the first channel 310A may be in contact with the first gate 302 while the second channel 310B may be in contact with the second gate 304. Thus, the first gate 302 may be positioned on the first channel 310A while the second gate 304 may be positioned on the second channel 310B. Here, the first gate 302 being positioned on the first channel 310A may include the first gate 302 being entirely positioned on the first channel 310A or being partially positioned on the first channel 310A. Similarly, the second gate 304 being positioned on the second channel 310B may include the second gate 304 being entirely positioned on the second channel 310B or being partially positioned on the second channel 310B. Further, the fin 310C may be positioned between the first gate 302 and the second gate 304.

In some examples, the semiconductor device 300 may further include a substrate 316, a first well 318 positioned on the substrate 316, and/or a second well 320 positioned on the substrate 316. In some examples, the substrate 316, the first well 318, and the second well 320 are substantially similar to the substrate 216, the first well 218, and the second well 220 in Fig. 2B.

In some examples, both semiconductor devices 200 of Figs. 2A and 2B and 300 of Figs. 3A and 3B may realize FinFET LDMOS without the need to have a long gate length, which is not available in some foundries. For example, both semiconductor devices 200, 300 exploit two gates, which are in contact with a channel, along with a connector to constitute a long gate. In some aspects, the total channel resistance and the current of the semiconductor device 200 in Figs. 2A and 2B may be lower and higher, respectively, than the transistor 300 in Figs. 3A and 3B. In further aspects, the leakage of the semiconductor 200 in Figs. 2A and 2B may be lower than the semiconductor device 300 in Figs. 3A and 3B.

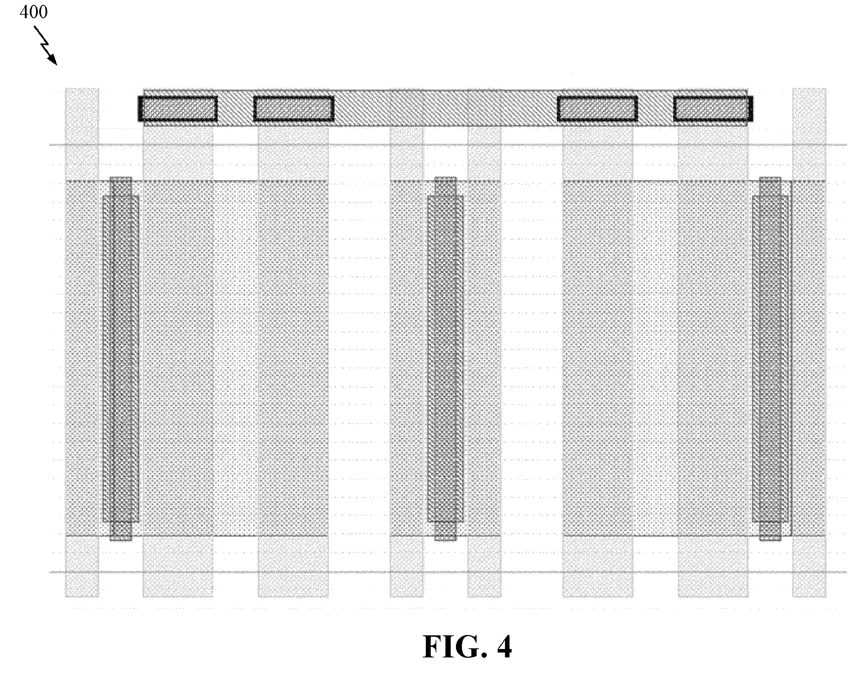

Fig. 4 is a schematic diagram illustrating a side view of an example semiconductor device 400, in accordance with various embodiments. In some examples, the semiconductor device 400 may include a first gate 402, a second gate 404, a source 406, and a drain 408. The semiconductor device 400 may be substantially similar to the semiconductor device 200 of Figs. 2A and 2B or the semiconductor device 300 of Figs. 3A and 3B.

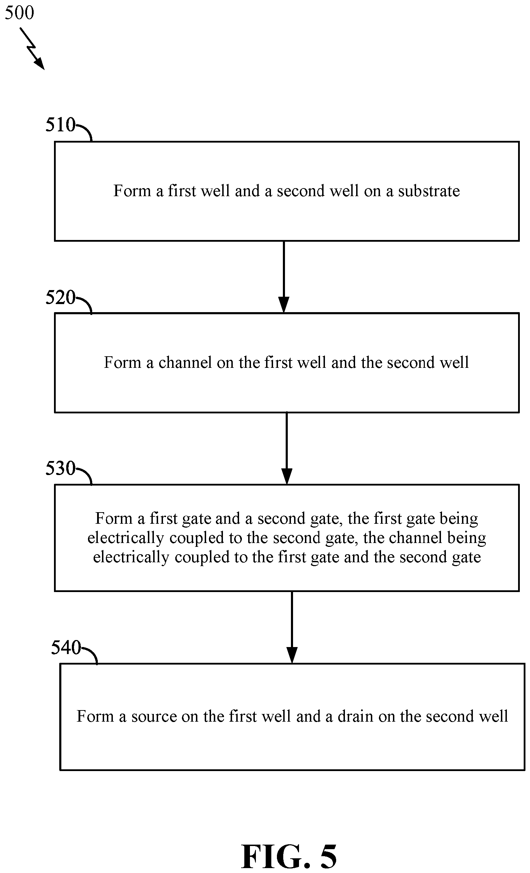

Fig. 5 is a flow chart illustrating an example process 500 for processing a semiconductor device in accordance with some aspects of the present disclosure. As described below, a particular implementation may omit some or all illustrated features, and may not require some illustrated features to implement all embodiments. In some examples, a controller with a processor and a memory may be configured to carry out the process 500. In some examples, any suitable apparatus or means for carrying out the functions or algorithm described below may carry out the process 500.

At block 510, the controller may form a first well and a second well on a substrate. In some examples, the substrate, the first well, and the second well are substantially similar to the substrate 216, the first well 218, and the second well 220 in Fig. 2B.

At block 520, the controller may form a channel on the first well and the second well. In some examples, the channel is substantially similar to the channel 210 in Fig. 2B, the first channel 310A, and the second channel 310B in Fig. 3B. In further examples, the controller may further form a fin positioned between the first channel and the second channel. In some examples, the fin is substantially similar to the fin 310C in Fig. 3B.

At block 530, the controller may form a first gate and a second gate. In some examples, the first gate may be electrically coupled to the second gate, and the channel may be in contact with the first gate and the second gate. In some examples, the first gate and the second gate are substantially similar to the first gate 202 and the second gate 204 in Fig. 2B. In some examples, a first distance of the first gate in a direction from the source to the drain is longer than a second distance of the second gate in the direction from the source to the drain. In some examples, the channel may consist of or include a single channel in contact with both of the first gate 202 and the second gate 204 as described with respect to Fig. 2B. Thus, one single channel can be in contact with both of the first gate 202 and the second gate 204In other examples, the channel may include the first channel and the second channel. In some examples, the first gate may be positioned on the first channel, and the second gate is positioned on the second channel. In further examples, the fin is positioned between the first gate and the second gate. In further examples, the controller may further position a connector on the first gate and the second gate to connect the first gate to the second gate. In some examples, the connector is substantially similar to the connector 213 in Fig. 2B.

At block 540, the controller may form a source on the first well and a drain on the second well. In some examples, the source and the drain are substantially similar to the source 206 and the drain 208 in Figs. 2A and 2B. In some examples, the source may include a first fin while the drain may include a second fin. Thus, the controller may form the source and the drain by forming the first find and the second fin, respectively. In further examples, when the channel includes the first channel and the second channel, the fin between the first channel and the second channel may be inserted along with the first fin as the source and the second fin as the drain. In other examples, when the channel includes one channel, the controller may prevent a fin from being inserted between the first channel and the second channel.

In some examples, "electrically coupled" includes a physical coupling configured to create an electrical coupling when current is applied. When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "placed" in some manner relative to another element (e.g., placed on, placed between, placed under, placed adjacent to, or placed in some other relative manner), it is to be understood that the elements can be directly placed relative to the other element (e.g., placed directly on another element), or have intervening elements present between the elements. In contrast, when an element is referred to as being "placed directly" relative to another element, it should be understood that no intervening elements are present in the "direct" example. However, the existence of a direct disposition does not exclude other examples in which intervening elements may be present.

When an element is described as being "over" or placed "over" another element, it is to be understood that such element can be said to be directly over (or placed on) the another element or have intervening elements present between the element and the another element. In some examples, When an element is described as being "over" or placed "over" another element, at least a portion of the element and at least a portion of the another element have an overlap in at least one axis. In contrast, when the element is referred to as being "directly over" or "directly placed over" another element, it should be understood that the entire element and at least a portion of the another element have an overlap in at least one axis or at least a portion of the element and the entire another element have an overlap in at least one axis.

In further examples, the phrase "at least one of" preceding a series of items, with the term "and" or "or" to separate any of the items, modifies the list as a whole, rather than each member of the list (i.e., each item). The phrase "at least one of' does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

While particular features and aspects have been described with respect to some embodiments, one skilled in the art will recognize that numerous modifications are possible. For example, the methods and processes described herein may be implemented using hardware components, software components, and/or any combination thereof. Further, while various methods and processes described herein may be described with respect to particular structural and/or functional components for ease of description, methods provided by various embodiments are not limited to any particular structural and/or functional architecture but instead can be implemented on any suitable hardware, firmware and/or software configuration. Similarly, while particular functionality is ascribed to particular system components, unless the context dictates otherwise, this functionality need not be limited to such and can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various embodiments. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various embodiments are described with-or without-particular features for ease of description and to illustrate some aspects of those embodiments, the various components and/or features described herein with respect to a particular embodiment can be substituted, added and/or subtracted from among other described embodiments, unless the context dictates otherwise. Consequently, although several embodiments are described above, it will be appreciated that the invention is intended to cover all modifications and equivalents within the scope of the following claims.

## Claims

1. A semiconductor device comprising:
a source;
a drain;
a first gate;
a second gate, the second gate being electrically coupled to the first gate, the first gate and the second gate positioned between the drain and the source;
a connector directly positioned on the first gate and the second gate; and
a channel being electrically coupled to the first gate and the second gate.

2. The semiconductor device of claim 1, wherein a first distance of the first gate in a direction from the source to the drain is longer than a second distance of the second gate in the direction from the source to the drain.

3. The semiconductor device of claim 1 or 2, wherein the channel is electrically coupled to the second gate by being in contact with the second gate.

4. The semiconductor device of any preceding claim, wherein the channel comprises a first channel and a second channel, and/or
wherein the first channel is in contact with the first gate, and/or
wherein the second channel is in contact with the second gate, and/or
wherein the semiconductor device further comprises a fin positioned between the first channel and the second channel.

5. The semiconductor device of claim 4, wherein the first gate is positioned on the first channel, and
wherein the second gate is positioned on the second channel.

6. The semiconductor device of claim 4 or 5, wherein the fin is positioned between the first gate and the second gate.

7. The semiconductor device of any preceding claim, wherein the channel consists of a single channel in contact with both of the first gate and the second gate.

8. The semiconductor device of any preceding claim, further comprising:
a second channel, the channel and the second channel being positioned in parallel relatively to each other in a direction between the source and the drain.

9. The semiconductor device of any preceding claim, wherein the channel comprises: silicon, silicon-germanium, or germanium.

10. The semiconductor device of any preceding claim, wherein the source comprises a first fin, and
wherein the drain comprises a second fin.

11. The semiconductor device of claim 10, wherein the first fin and the second fin comprise an in-situ phosphorous or boron doped epitaxy.

12. The semiconductor device of any preceding claim, further comprising:
a substrate;
a first well positioned on the substrate; and
a second well positioned on the substrate,
wherein the source is positioned on the first well,
wherein the drain is positioned on the second well,
wherein the channel is positioned on the first well, and
wherein the first gate is positioned on the first well.

13. The semiconductor device of claim 12, wherein the second gate is in contact with the channel, and
wherein the second gate is positioned over at least one of the first well or the second well.

14. A method for processing a semiconductor device, comprising:
forming a first well and a second well on a substrate;
forming a channel on the first well and the second well;
forming a first gate and a second gate, the first gate being electrically coupled to the second gate, the channel being electrically coupled to the first gate and the second gate;
directly positioning a connector on the first gate and the second gate to physically connect the first gate to the second gate; and
forming a source on the first well and a drain on the second well.

15. A semiconductor device comprising:
a source,
a drain;
a first gate;
a second gate, the first gate and the second gate positioned between the drain and the source;
a connector directly positioned on the first gate and the second gate to physically connect the first gate to the second gate; and
a channel being electrically coupled to the first gate and the second gate, the channel being in contact with the second gate.
